# FASCICULE DE BREVET EUROPEEN

(11) **EP 4 174 530 B1**
(45) Date de publication et mention de la délivrance du brevet: **20.08.2025**
(21) Numéro de dépôt: 22204318.4
(22) Date de dépôt: 28.10.2022
(51) Int. Cl.: G01V 3/165, H03G 3/30

(54) **RESTITUTION AUDIO D'UN SIGNAL DE DÉTECTION ÉLECTROMAGNÉTIQUE DE MÉTAUX**
AUDIOWIEDERGABE EINES ELEKTROMAGNETISCHEN METALLDETEKTIONSSIGNALS
AUDIO RENDERING OF AN ELECTROMAGNETIC METAL DETECTION SIGNAL

(30) Priorité: 01.11.2021 FR 2111596
(43) Date de publication de la demande: 03.05.2023
(73) Titulaire: SARL XPLORER, 31320 Castanet-Tolosan (FR)
(72) Inventeur: VERN, Jean-Louis, 34470 Perols (FR)
(74) Mandataire: BARRE LAFORGUE

(56) Documents cités:
- WO-A2-00/15001
- DE-A1- 102005 018 590
- DE-A1- 4 212 363
- DE-U1- 29 811 404
- ANONYMOUS: "DEUS V5 - USER'S MANUAL", 4 July 2018 (2018-07-04), XP055936228, Retrieved from the Internet <URL:https://smhttp-ssl-37061.nexcesscdn.net/media/_docs/Manual/EN/XP_DEUS_5_Manual_EN.pdf> [retrieved on 20220628]
- GIFFORD VINCE: "Outlaw Operator Instruction Manual", 12 June 2012 (2012-06-12), XP055933183, Retrieved from the Internet <URL:https://www.metaldetector.com/media/_docs/Manual/EN/Tesoro_Outlaw_Manual.pdf> [retrieved on 20220620]
- HARRY NEUTEBOOM ET AL: "A DSP-Based Hearing Instrument IC", IEEE JOURNAL OF SOLID-STATE CIRCUITS, IEEE, USA, vol. 32, no. 11, 1 November 1997 (1997-11-01), XP011060607, ISSN: 0018-9200

## Description

### [Domaine technique]

La présente invention se rapporte de manière générale au domaine de la détection de métaux au moyen de détecteurs électromagnétiques portatifs, et plus particulièrement à la restitution audio d'un signal de détection électromagnétique de métaux.

De tels détecteurs de métaux sont utilisés essentiellement pour le loisir, par exemple pour la recherche et la discrimination d'objets métalliques enfouis dans le sol comme des pièces de monnaie, bijoux, trésors ou pépites d'or, mais aussi par les professionnels, par exemple pour le déminage, les recherches en balistique, ou encore la recherche de tuyauteries dans l'industrie du bâtiment ou de particules métalliques polluantes dans le secteur alimentaire. Ces exemples d'application ne sont pas limitatifs. Les détecteurs de métaux portatifs modernes permettent à l'utilisateur non seulement de repérer mais aussi d'identifier une cible enfouie dans le sol.

### [Arrière-plan technologique]

Usuellement, les détecteurs de métaux comprennent une tête de détection électromagnétique, ou plus simplement tête détection ou disque de détection, qui constitue la partie active du détecteur, et qui est montée à l'extrémité d'une canne de manutention. Cette tête de détection adopte la forme d'un disque car elle comprend une ou plusieurs bobines inductives qui permettent de générer un champ électromagnétique incident, et de recevoir un champ magnétique résultant modifié par l'environnement immédiat.

La tête de détection peut aussi embarquer une électronique de commande, adaptée pour produire un signal électromagnétique alternatif à l'origine du champ électromagnétique incident, et pour traiter un signal de détection électromagnétique reçu correspondant au champ magnétique résultant. Ce traitement permet de détecter et de discriminer d'éventuels objets métalliques exposés au champ électromagnétique incident. En variante, la tête de détection n'embarque qu'une partie de l'électronique d'exploitation du signal de détection électromagnétique reçu, par exemple un préamplificateur, le reste de cette électronique étant déporté dans un boîtier de commande auquel la tête de détection est connectée.

Dans les détecteurs électromagnétiques portatifs fonctionnant en mode à ondes entretenues, aussi appelé détecteurs à onde continue (ou CW, de l'anglais *"Continuous Wave"*)*,* un champ magnétique alternatif est émis "en continu" et la détection se base sur les variations d'amplitude et de phase entre les composantes fréquentielles du signal émis celles du signal reçu. Plus particulièrement, les détecteurs CW utilisent la mesure d'amplitude et de phase des différentes composantes du signal électromagnétique alternatif émis par une au moins une bobine émettrice alimentée par une tension électrique, et les composantes du signal électromagnétique reçu par une ou plusieurs bobines réceptrices disposées de manière proche de la bobine émettrice. La fréquence du signal émis par la bobine émettrice est généralement inférieure à 100 kHz. Dans certaines réalisations, la bobine émettrice et la (ou les) bobine(s) réceptrice(s) ne sont qu'une seule et même bobine.

La mise en œuvre du principe de la balance d'induction (ou IB, de l'anglais *"induction balance"*) permet de mesurer par induction des changements très faibles des propriétés du milieu. La réalisation se fait en disposant les bobines d'émission et de réception de manière que l'inductance mutuelle de la ou des bobines de réception et de la ou des bobines d'émission soit la plus faible possible. Ceci permet de minimiser le champ électromagnétique mesuré en l'absence de cible. Le couplage des deux bobines est alors tel, en effet, que le signal reçu par la bobine réceptrice est sensiblement nul lorsque aucun élément métallique n'est placé dans le champ de la bobine émettrice. Cela permet d'optimiser la dynamique du signal de mesure en ne mesurant que les variations du champ électromagnétique résultant.

La configuration la plus courante est celle de la tête "double D" mais d'autres configurations sont possibles, par exemple avec des bobines concentriques, ou en mettant les bobines à 90° l'une par rapport à l'autre, ou encore avec des bobines auxiliaires utilisées pour générer un champ de compensation, ou bien avec d'autres géométries encore.

Par ailleurs, il existe d'autres types de détecteurs de métaux qui, au lieu de travailler dans le domaine "fréquentiel", travaillent dans le domaine "temporel". Dans ce cas, ce ne sont pas les amplitudes et les phases relatives entre les composantes fréquentielles du signal émis et du signal reçu qui sont analysées, mais plutôt la forme du signal reçu. Cela peut sembler similaire car il y a une correspondance (en passant par les transformées de Fourier) entre le domaine temporel et le domaine fréquentiel, mais généralement cela recouvre, en plus, une manière différente de générer le champ magnétique émis. En effet, alors que dans le cas d'un détecteur CW le signal est émis de manière continue, dans le cas d'un détecteur en mode à induction pulsée (ou "PI", de l'anglais *"Pulsed Impulsion"*) un signal impulsionnel est généré durant quelques dizaines de microsecondes (µs) dans la tête de détection, puis le signal reçu après cette excitation magnétique du milieu ambiant est reçu et analysé. La même bobine peut alors servir alors alternativement pour générer une impulsion et pour analyser le champ reçu. Mais on peut aussi utiliser deux bobines, à savoir l'une pour l'émission et l'autre pour la réception dans des configurations variées (par exemple la configuration "double D" précitée, ou d'autres). Dans tous les cas, le signal reçu peut être vu comme la somme de différentes décroissances exponentielles qui sont représentatives du milieu dans lequel on opère. Les signaux associés aux sols ou à l'eau salée ont des décroissances exponentielles généralement rapides, avec des constantes de temps inférieures à quelques µs, alors que les cibles intéressantes ont des constantes de temps plus importantes. Bien évidemment, le signal d'excitation doit être renouvelé périodiquement (en général avec une récurrence d'environ 1 kHz) et le signal reçu est "moyenné" pour être exploité, mais le traitement se fait dans le domaine temporel et pas dans le domaine fréquentiel.

On peut aussi avoir des détecteurs qui travaillent simultanément dans les deux modes, à savoir le mode CW et le mode PI.

Lors d'une séance de détection, l'utilisateur arpente une zone déterminée à explorer en balayant le terrain avec le détecteur portatif, par l'intermédiaire de la canne de manutention, ce qui lui évite de devoir se baisser ou se pencher. Plus particulièrement, il se tient debout et déplace le disque de détection parallèlement au sol à l'aide de la canne, en effectuant un balayage de la tête de détection de gauche à droite, puis de droite à gauche, et ainsi de suite. La bobine d'émission produit un champ magnétique qui, au niveau d'une éventuelle cible métallique qui est fixe, varie dans le temps du fait que la tête de détection est ainsi mise en mouvement. Ce champ magnétique génère des courants de Foucault dans la cible métallique que l'on cherche à détecter.

Ces courants génèrent à leur tour des champs magnétiques qui sont captés par la bobine de réception (qui est parfois la même que la bobine d'émission). Le signal électromagnétique reçu, aussi appelé signal de détection de la cible ou plus simplement signal de détection ou juste signal dans ce qui suit, a une amplitude qui varie quand la tête de détection se déplace au-dessus de la cible, proportionnellement aux champs magnétiques produits par la circulation des courants de Foucault générés dans la cible, et reçus par la tête de détection. Le signal électromagnétique reçu est alors amplifié et traité par l'électronique de commande, de manière à isoler le signal associé à la cible recherchée et à le séparer des signaux parasites (parasites industriels, météorologiques, variation associée au sol, au champ magnétique terrestre, cibles parasites, etc.).

La plage effective de détection du détecteur de métaux dépend du type de cible et de la technologie utilisée par le fabriquant du détecteur. Elle est limitée par le rapport signal-sur-bruit (*"Signal-to-Noise Ratio"* ou SNR, en anglais) qui dépend des caractéristiques physiques de l'électronique de commande du détecteur de métaux, du traitement de signal mis en œuvre et des différents signaux parasites auxquels est soumis le disque de détection. La majorité des détecteurs ont donc un réglage de seuil en dessous duquel le signal de détection n'est pas pris en compte, soit parce qu'il se situe dans le bruit, soit parce que l'on souhaite délibérément ignorer des cibles de trop petite taille.

D'autres informations sont déduites des signaux analysés par la tête de détection. Ce sont des informations dites de "discrimination", qui enrichissent l'information principale relative au niveau d'intensité du signal de détection de la cible, avec des données concernant les caractéristiques de la cible (par exemple sa nature ferreuse ou non ferreuse) et/ou de son environnement (par exemple les caractéristiques du sol comme la conductivité). La pertinence de ces informations de discrimination est très dépendante du rapport signal-sur-bruit du détecteur.

Les informations d'amplitude et de discrimination du signal peuvent être restituées à l'utilisateur par différents canaux sensoriels, notamment auditif ou visuel. La restitution audio est préférable, et la plus utilisée, car elle permet à l'utilisateur de rester concentré sur le balayage du sol avec la tête de détection.

Le document intitulé "DEUS V5 USER'S MANUAL" est un manuel utilisateur qui décrit plusieurs fonctions et réglages disponibles pour un détecteur de métaux. Le document "Outlaw Operator Instruction Manual" est aussi un manuel d'utilisation d'un autre détecteur de métaux.

Le document WO0015001 A2 décrit un système de correction auditive pour personnes ayant une déficience auditive, dans lequel il est prévu de segmenter un signal audio en trois régions auxquelles sont appliqués différents gains.

### [Technique antérieure]

Les approches décrites dans cette sous-section pourraient être appliquées, mais ne sont pas nécessairement des approches qui ont été conçues ou appliquées précédemment. Par conséquent, sauf indication contraire dans le présent texte, les approches décrites dans cette section ne constituent pas un état de la technique antérieur à la présente demande et ne sont pas reconnues comme telles par leur inclusion dans cette section.

Le signal de détection a une amplitude qui varie quand la tête de détection se déplace au-dessus de la cible proportionnellement aux champs magnétiques produits par la circulation des courants de Foucault générés dans la cible et reçus par la tête de détection. L'analyse de ce signal permet de détecter des cibles, en fournissant à l'utilisateur des indications pour l'aider dans la détection et l'identification de cibles métalliques. Ces indications sont extraites du signal de détection électromagnétique par des techniques de traitement de signal connues en soi. Elles sont généralement présentées, i.e. restituées à l'utilisateur sous forme sonore à l'aide d'un transducteur électroacoustique comme, par exemple, un casque audio. A cet effet un signal audio est généré à partir du signal de détection électromagnétique et est délivré au casque audio de l'utilisateur, par exemple un casque sans fil.

Des méthodes des restitution audio qui peuvent être utilisées consistent à générer un son dont l'amplitude et/ou la fréquence sont modulées par l'amplitude du signal détecté. Par exemple, le signal audio d'amplitude la plus forte peut indiquer la position de la cible la plus proche du disque de détection. On peut aussi utiliser une telle modulation d'amplitude du signal, dont la fréquence est en outre déterminée par les informations de discrimination. Également, on peut moduler simultanément l'amplitude et la fréquence du signal audio en fonction du signal de détection. Généralement, le signal audio le plus fort et le plus aigu indique la position de la cible la plus proche du disque de détection. On peut aussi réaliser une modulation d'amplitude et/ou de fréquence en réservant certaines gammes de fréquence pour certains types de cible, et d'autres gammes de fréquence pour d'autres types de cible, respectivement. Ainsi, les cibles ferreuses peuvent par exemple être signalées par des fréquences beaucoup plus basses que les cibles non-ferreuses.

Il est également possible de moduler l'amplitude du signal audio en faisant varier le rapport cyclique d'un signal rectangulaire attaquant le transducteur électroacoustique. Par exemple, le rapport cyclique de celui-ci passe de 0% pour un signal de détection nul à 50% (i.e., à un signal carré) pour le signal de détection le plus fort. Outre la simplicité de la réalisation au niveau matériel (*"hardware"* en anglais), ceci présente l'avantages de coupler la variation d'amplitude du signal audio à une variation spectrale, c'est-à-dire une variation du contenu fréquentiel de ce signal audio, ce qui permet à l'utilisateur une meilleure analyse sensorielle qu'une variation d'amplitude pure, tout en réservant la possibilité d'une modulation de fréquence pour lui indiquer des informations de discrimination.

Différents réglages peuvent permettre de régler le seuil de détection à partir duquel un son est généré (aucun son n'étant produit pour un signal de détection au-dessous de ce seuil) ainsi que le niveau sonore du signal audio restitué, et éventuellement de modifier les différentes fréquences utilisées pour la génération du son. En l'absence de modulation de fréquence, le son peut être coupé (*"mute"* en anglais) quand le niveau de la cible est inférieur au seuil sélectionné par l'utilisateur, ou que le détecteur détecte des cibles particulières (ferrite par exemple). Le cas échéant, l'utilisation de la modulation de fréquence pour indiquer l'amplitude du signal de détection de la cible peut inclure un réglage permettant d'ajuster le niveau du son continu qui est produit en l'absence de cible (*"baseline"* en anglais), ou d'opter pour l'absence de signal audio ("mute"), ainsi qu'un réglage de la fréquence de base, c'est-à-dire la fréquence de ce son continu.

Un problème demeure, néanmoins, en ce qui concerne la prise en compte de de la dynamique du signal de détection dans le signal audio restitué. On notera que, dans le contexte de l'invention et dans la cadre de la présente description, le terme "dynamique" appliqué au signal de détection s'entend de l'écart entre l'amplitude la plus basse et l'amplitude la plus haute dudit signal de détection. Par ailleurs, lorsqu'il est utilisé en référence au signal audio restituant sous forme sonore le signal de détection à l'utilisateur, le terme "dynamique" s'entend de l'écart entre le niveau sonore le plus faible et le niveau sonore le plus fort dudit signal audio. Dans un cas comme dans l'autre, l'écart est généralement exprimé en décibels (dB), qui est une unité de mesure relative, sur une échelle logarithmique, entre un niveau donné et un niveau de référence déterminé.

On observe en effet que la dynamique du signal associé aux cibles métalliques est très importante. Elle peut couramment dépasser 100 dB suivant que la cible est petite et lointaine, d'un côté, ou bien grosse et proche, d'un autre côté. Or, si la modulation d'amplitude d'un signal sonore est utilisée pour traduire, *i.e.*, restituer la variation d'amplitude du signal cible, celle-ci produit des variations de niveau sonore qui excédent les possibilités de l'oreille humaine.

La dynamique du système auditif humain est théoriquement d'environ 120 dB à 1kHz, mais la plage dynamique utile est en fait beaucoup plus réduite. Dans les valeurs maximales, la limite est donnée par les dommages que peuvent entrainer des niveaux trop importants. La directive européenne 2003/10/CE, par exemple, préconise à cet égard de ne pas exposer les salariés des entreprises à des niveaux sonores de plus de 80 dB SPL(A), où l'acronyme SPL désigne le niveau de pression acoustique (*"Sound Pressure Lever*", en anglais), pendant huit heures. Également, la limite autorisée par la législation européenne pour les baladeurs audio est de 85 dB SPL (A). Pour les valeurs minimales de la plage dynamique, la restitution du signal audio est limitée par le bruit de fond dans lequel on est immergé. À l'intérieur d'un espace de bureau calme, le bruit de fond est de l'ordre de 40 dB SPL (A), et il peut être de l'ordre de 30 dB SPL (A) dans un environnement extérieur calme, par exemple en forêt. Mais il peut être beaucoup plus élevé dans d'autres environnements extérieurs, typiquement de l'ordre de 43 à 48 dB SPL (A) dans la jungle, par exemple. Or, pour être clairement perceptible par l'oreille humaine, un signal sonore doit avoir niveau sonore d'une dizaine de décibels au-dessus de celui du bruit de fond. On obtient donc une plage utile de niveaux sonores typiquement comprise entre 30 et 48 dB(A) plus 10 dB(A) d'un côté pour les sons faibles, et 85 dB(A) de l'autre côté pour les sons forts, soit une dynamique de 27 dB à 45 dB.

L'excédent de dynamique entre la dynamique du signal de détection (soit plus de 100 dB) et la dynamique souhaitable du signal audio pour la restitution sonore à l'utilisateur (de 27 dB à 45 dB) est donc de l'ordre de 50 à 80 dB. Avec la restitution du signal de détection par modulation en amplitude d'un signal sonore, l'utilisateur a alors le choix, soit de baisser le niveau sonore global ce qui réduit l'amplitude du signal audio uniformément dans toute sa plage de variation, quitte à ne plus entendre les cibles relativement petites et/ou éloignées, soit de régler le niveau sonore associé aux petites cibles de manière à les entendre confortablement, mais au risque d'être gêné par un niveau sonore trop important en cas de détection de cibles relativement grosses et/ou proches. Dans des cas extrêmes, des niveaux sonores trop importants risquent d'entrainer des pertes auditives chez l'utilisateur.

Dans l'article scientifique intitulé « Auditory issues in Hand-Held Landmine Detector », par Nancy L. Vause et. al., Conférence SPIE « Detection and Remediation Technoloqjes for Mines and Minelike Targets IV », Orlando, Floride, SPIE Vol. 3710 (avril 1999), les auteurs relèvent que de nombreux détecteurs disponibles dans le commerce utilisent des signaux acoustiques qui sont restitués avec un niveau considéré comme gênant ou qui peuvent obliger l'utilisateur à procéder à un changement temporaire de seuil de détection.

Dans l'article intitulé « Auditory signals for enhanced operator performance with hand-held mine detector », par Gene Ferguson et al., dans « Detection and Remediation Technologies for Mines and Minelike Targets V », Proceedings of SPIE Vol. 4038 (2000), les auteurs (en partie communs avec ceux de l'article ci-dessus) notent que cette question nécessite une attention urgente car l'interface audio actuelle du système de détection HSTAMIDS (mis pour « *Hand-held Stand-off Mine Detection System* » en anglais) est capable de générer des signaux acoustiques à hauteur de 120 dB (MD) et 114 dB SPL (GPR), pour les technologies GPR (mis pour « *Modem Ground Penetrating* Radar » en anglais) et MD (mis pour « *Metal Detection* » en anglais), respectivement, qui dépassent les niveaux sonores des présentations non dangereuses pour les applications militaires et civiles. En outre, ils relèvent que le sous-système MD actuel du système HSTAMIDS génère un signal de base continu qui peut atteindre 83 dB SPL avec le contrôle du volume complètement ouvert.

Les brevets US 4,594,559 et US 4,644,290 (1987) délivrés à David S. BERNZWEIG, qui ont pour objet un amplificateur audio d'un détecteur de métaux, divulguent un dispositif accessoire à utiliser avec un détecteur de métaux et ayant des moyens pour amplifier la sortie audio basse du détecteur de métaux, qui est à peine audible, de sorte qu'elle puisse être facilement entendue avec des moyens supplémentaires qui sont adaptés pour amortir les signaux de sortie audio plus forts en rendant ces signaux plus faibles. Ce dispositif permet de limiter la dynamique du signal de manière très frustre et introduit des déformations du signal, ce qui ne le rend pas utilisable avec des appareils modernes.

Certains fabricants de détecteurs de métaux (par exemple la société MINELAB ELECTRONICS PTY LTD, sur ses modèles GPX4000^{™}, GPX4500^{™}, GPZ7000^{™}, ...) sont conscients du problème et ajoutent un réglage de limitation de volume (*"Volume Limit*" en anglais) qui permet d'écrêter le volume du son émis par le détecteur à une valeur limite haute. Le fabricant met en garde l'utilisateur dans la notice d'utilisation d'un de ces modèles, en ces termes très explicites (traduction libre) : *« Si la limite de volume est réglée au maximum, tous les signaux de la cible seront entendus, et le son sera proportionnel à la taille et à la profondeur de la cible. La limite maximale vous permet d'entendre la différence entre une petite et une grande cible, mais peut être inconfortable pour votre audition si une grande cible* se *trouve près de la bobine »* ; ou encore : *« Si la limite de volume est réglée au minimum, la plupart des signaux de cible seront potentiellement très limités. Un volume faible sera plus confortable pour votre audition mais augmentera le risque de manquer des cibles ».* Le même fabricant met aussi en garde les utilisateurs de ses modèles par l'avertissement suivant : *« Attention : le détecteur est capable de produire un volume extrêmement élevé si une cible large ou peu profonde est localisée. Protégez vos oreilles !* ».

En d'autres termes, cela signifie que le réglage de limitation de volume et les procédés basés sur la limitation de l'amplitude du signal audio permettent effectivement de diminuer le niveau maximal du signal audio qui est présenté à l'utilisateur, mais que les variations dynamiques du signal de détection correspondant à la zone de la dynamique audio dans laquelle cette limitation intervient sont alors complètement annihilées.

L'utilisation, pour la restitution sonore, d'un signal rectangulaire dont le rapport cyclique varie avec le niveau du signal de détection de la cible, procure un avantage. En effet, si la valeur efficace d'un signal impulsionnel varie linéairement avec le rapport cyclique de celui-ci, il n'en va pas de même du niveau sonore ressenti (*"loudness"* en anglais). En effet, si on observe le contenu spectral de différents signaux rectangulaires avec des rapports cycliques différents, on constate que la répartition spectrale de l'énergie varie considérablement. Plus le rapport cyclique est faible, et plus (relativement au fondamental) le contenu harmonique devient riche, pour aboutir à un spectre « plat » dans les fréquences audibles pour des rapport cycliques inférieurs à 1% (pour des fréquences de 500 Hz ou plus). Or, la sensation de niveau sonore telle qu'elle est perçue par un être humain varie de manière complexe avec la composition spectrale et le niveau sonore.

Par exemple, la norme ISO 226:2003 montre les courbes d'iso-phonie (i.e., niveau ressenti égal) en fonction de la fréquence et de la pression acoustique pour des sons purs (signal sinusoïdal), qui illustrent clairement cette variation de ressenti.

Pour des signaux complexes comme ceux correspondant à un signal rectangulaire de rapport cyclique variable, la courbe d'iso-phonie est plus difficile à élaborer, car elle dépend de manière complexe de l'énergie présente dans différentes bandes de fréquences analysées par l'oreille. Celles-ci, appelées bandes critiques, ont une largeur d'environ 0,2 x F pour des fréquences F de plus de 500 Hz ce qui implique que, pour un signal dont le fondamental est à 500 Hz (qui est une fréquence fondamentale de signal audio typiquement utilisée), les dix premières harmoniques se trouvent dans des bandes critiques distinctes et contribuent chacune à la sensation de niveau sonore globale. Ces dix premières harmoniques se trouvent aussi dans la zone de sensibilité maximale de l'oreille, et ce d'autant plus que le niveau acoustique est faible. Ainsi, quand le rapport cyclique diminue, l'augmentation relative de l'amplitude des premières harmoniques dans les différentes bandes critiques analysées par l'oreille compense dans une large mesure la diminution de la valeur efficace du signal dans son ensemble (et ce d'autant plus que le signal diminue), ce qui concours à une sensation de niveau constant alors même que la valeur efficace du signal rectangulaire diminue. Il en résulte une sorte de « compression de la dynamique » naturelle si ce type de signal rectangulaire à rapport cyclique modulé est utilisé. Cette « compression de la dynamique » dépend beaucoup des dispositifs de restitution sonore, notamment de la qualité du casque audio et/ou du haut-parleur, et de leurs facultés à restituer lesdites harmoniques, ainsi que de la sensibilité de l'oreille de l'utilisateur : les pertes auditives produisent souvent une atténuation dans des fréquences aux alentours de 4000 Hz dans la zone dans laquelle les variations de niveau des harmoniques du signal est particulièrement sensible, ce qui affecte l'effet de cette compression dynamique pour les utilisateurs affectés de telles pertes auditives.

Cette compression dynamique peut atteindre une trentaine de dB dans le meilleur des cas pour un signal à 500 Hz. Pour améliorer encore cette compression, on pourrait modifier la courbe de variation de la valeur du rapport cyclique de manière à privilégier la variation dynamique ressentie dans telle ou telle zone de la dynamique du signal de détection. Cette adaptation dynamique a toutefois des limites, car elle s'inscrit dans le cadre d'un signal rectangulaire de rapport cyclique variable dont le son, pour des faibles niveaux (et donc pour des rapports cycliques faibles), peut être désagréable en raison de son contenu harmonique particulièrement riche.

### [Exposé de l'invention]

L'objet de l'invention est d'améliorer la dynamique des signaux audio générés par un détecteur de métaux, de manière que les signaux les plus faibles soient audibles, que les signaux les plus forts ne provoquent pas de gêne auditive, et que l'appréciation du volume sonore puisse être réalisée graduellement pour les signaux de niveaux intermédiaires.

Ce but est atteint, conformément à des modes de réalisation, en modifiant la dynamique du signal électromagnétique de détection de la cible, de manière à rendre cette dynamique compatible avec la dynamique réellement utilisable du système auditif humain.

À cette fin, un premier aspect de l'invention propose un procédé selon la revendication 1.

La segmentation de la dynamique du signal de détection en plusieurs portions et l'application à chacune de ces portions de taux de modification de dynamique respectifs, a pour effet que la modification globale de la dynamique du signal de détection peut être plus complexe, ce qui donne un signal audio avec un ressenti potentiellement meilleur pour l'utilisateur.

Selon un mode de mise en œuvre particulier, des portions de la dynamique du signal de détection sont définies par des segments linéaires. La réalisation est ainsi plus simple.

Selon un mode de mise en œuvre particulier, au moins un taux de modification locale de dynamique est supérieur ou égal à l'unité. Ainsi, et nonobstant la compression globale de la dynamique, des portions locales de la dynamique peuvent être magnifiées par extension de la dynamique localement.

Le procédé peut en outre comprendre, avant l'étape de réduction de la dynamique du signal de détection, une conversion logarithmique dudit signal de détection suivant une échelle logarithmique, et l'application du taux de compression globale de dynamique au signal de détection écrêté ou l'application d'un taux de modification locale de dynamique à une portion déterminée du signal de détection écrêté, peut alors comprendre la multiplication dudit signal de détection écrêté ou de ladite portion du signal de détection écrêté, respectivement, par ledit taux de compression globale de dynamique ou par ledit taux de modification locale de dynamique, respectivement. Les calculs sont donc plus simples à réaliser par un processeur, puisqu'il s'agit d'une simple multiplication des valeurs de l'amplitude du signal de détection sur l'échelle logarithmique.

Le procédé peut en outre comprendre, après la réduction de la dynamique du signal de détection et avant la génération du signal audio, une conversion inverse de la conversion logarithmique du signal de détection reçu afin de ramener la dynamique du signal de détection compressé et décalé sur une échelle linéaire.

Selon un mode de mise en œuvre particulier, le décalage du signal de détection compressé peut alors comprendre l'ajout d'une valeur correspondant à un niveau minimal désiré du signal audio.

Selon un mode de mise en œuvre particulier, le seuil de détection et/ou la valeur correspondant au niveau minimal désiré du signal audio sont programmables. Ces paramètres peuvent ainsi être réglé par l'utilisateur en fonction de ses attentes et/ou de son expérience dans la détection de métaux.

Dans un mode de mise en œuvre particulier, la génération du signal audio peut comprendre la génération d'un signal acoustique ayant une composante fondamentale de hauteur déterminée, ainsi que la modulation dudit signal acoustique par le signal de détection compressé et décalé.

Selon un mode de mise en œuvre particulier, la génération du signal audio comprend en outre un changement de timbre du signal acoustique, entre deux portions respectives de la dynamique du signal de détection. Le signal audio est ainsi nuancé par des contenus spectraux légèrement modifiés d'une zone à l'autre de la dynamique du signal de détection, en plus de la variation du niveau sonore.

Pour une meilleure expérience de l'utilisateur, le changement de timbre du signal acoustique entre deux portions contigües de la dynamique du signal de détection peut être progressif de l'une à l'autre.

Selon un mode de mise en œuvre particulier, la réduction de la dynamique du signal de détection reçu comprend en outre, après l'écrêtage du signal de détection mais avant l'application au signal de détection écrêté du taux de compression globale de dynamique, un redressement simple alternance dudit signal de détection écrêté. En d'autres termes, les éventuelles valeurs négatives de la dynamique du signal de détection après soustraction de la valeur du seuil d'audibilité sont éliminées. On s'assure ainsi d'avoir une valeur minimale qui est égale à zéro en entrée de la partie avale de la chaîne de traitement.

Dans un deuxième aspect, l'invention propose également un produit programme d'ordinateur comprenant des instructions qui, lorsque le programme est exécuté par un ordinateur, conduisent celui-ci à mettre en œuvre les toutes étapes du procédé selon le premier aspect.

Un troisième aspect concerne un dispositif de traitement de données comprenant un processeur configuré pour mettre en œuvre toutes les étapes du procédé selon le premier aspect.

Enfin, un quatrième et dernier aspect de l'invention se rapporte aussi à un appareil de détection de métaux portatif comprenant un dispositif selon le troisième aspect ci-dessus ainsi qu'au moins un transducteur électroacoustique pour restituer le signal audio à un utilisateur de l'appareil.

### [Brève description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig. 1] la figure 1 est une réprésentation schématique des principaux éléments fonctionnels d'un exemple de détecteur de métaux en conditions d'utilisation, lors d'une séance de détection conduite par un utilisateur ;
[Fig. 2] la figure 2 est un schéma fonctionnel réprésentant, sous la forme d'un schéma-blocs, l'architecture d'un détecteur électromagnétique de métaux apte à la mise en œuvre du procédé de restitution audion selon des modes de réalisation ;
[Fig. 3] la figure 3 est un graphe de l'évolution, en fonction de la distance "d" entre la tête de détection et la cible, de l'atténuation (en décibels, ou dB) de l'amplitude du signal de détection électromagnétique issu de la tête de détection d'un détecteur de métaux ;
[Fig. 4] la figure 4 est un diagramme fonctionnel (schéma-blocs) d'un dispositif selon des modes de réalisation de l'invention, adapté pour la mise en œuvre du procédé selon des modes de mise en œuvre de l'invention ;
[Fig. 5] la figure 5 est un graphe montrant l'évolution, en fonction du temps, d'un exemple de signal électromagnétique de détection tel qu'issu de la tête de détection lors d'un unique mouvement de balayage de la tête de détection d'un détecteur de métaux au-dessus d'une cible ;
[Fig. 6] la figure 6 donne des graphes d'un exemple de signal audio pour la restitution sonore du signal de la figure 4 selon une méthode à dynamique constante, pour des valeurs de gain respectives ;
[Fig. 7] la figure 7 donne un graphe d'un exemple de signal audio pour la restitution sonore du signal de la figure 4 en implémentant une méthode de limitation de la dynamique du signal audio par écrêtage haut et bas ;
[Fig. 8] la figure 8 donne un graphe d'un exemple de signal audio pour la restitution sonore du signal de la figure 4 en implémentant la méthode de compression de la dynamique conforme à des modes de mises en œuvre de l'invention ;
[Fig. 9] la figure 9 donne les graphes de la figure 7 et de la figure 8 superposés l'un à l'autre, pour illustrer la comparaison entre la forme du signal audio pour la restitution sonore du signal de la figure 4 selon la méthode de limitation de la dynamique du signal audio par écrêtage haut et bas et la forme de ce signal audio pour la restitution sonore selon la méthode de compression de la dynamique conforme à des modes de mises en œuvre de l'invention, respectivement ; et,
[FIG. 10] la figure 10 est un graphe illustrant un mode de mise en œuvre dans lequel le signal de détection de la cible est segmenté de manière à définir plusieurs zones dans lesquelles on peut avoir des niveaux de compression respectifs différents.

### [Description de mode(s) de réalisation]

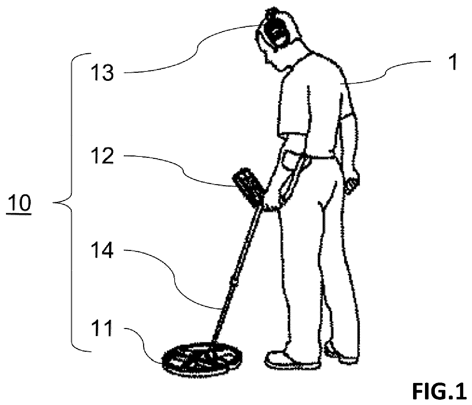

En référence à la **figure 1****,** un détecteur de métaux 10 moderne possède une architecture en trois éléments, ces trois éléments communiquant entre eux par liaison numérique sans fil, par exemple une liaison radio. Ces trois éléments sont :
- premièrement un disque de détection ou encore tête de détection qui incorpore la (ou les) bobine(s) d'émission et/ou de réception ;
- deuxièmement un module de commande 12, aussi appelé télécommande, qui permet de paramétrer l'ensemble des fonctions variées du détecteur grâce à une interface homme-machine (ou HMI, de l'anglais "Human-Machine Interface") adaptée ; ainsi que,
- troisièmement un dispositif de restitution audio 13, qui peut être un casque audio filaire ou de préférence un casque audio sans fil, un ou plusieurs haut-parleurs ou un dispositif à conduction osseuse, comprenant des transducteurs électroacoustiques (par exemple un pour chaque oreille) aptes à restituer le signal de détection sous forme audible par l'utilisateur.

On notera que tout ou partie de l'électronique de gestion de l'émission, de la réception, et de traitement des signaux de détection pour réaliser la détection et la discrimination des cibles peut être intégrée dans la tête de détection, ou dans la télécommande, ou bien être répartie entre la tête de détection et la télécommande.

En outre, le détecteur est généralement fourni avec, en accessoire, une canne ayant une poignée et un repose-bras. L'extrémité de la canne opposée au repose-bras et à la poignée est adaptée pour supporter le disque de détection, qui peut lui être couplé de manière amovible. La télécommande est adaptée pour être fixée sur la canne, juste en avant de la poignée comme montré à la figure 1.

Ainsi, lorsque l'utilisateur 1 étend devant lui la canne ainsi munie du disque de détection et de la télécommande, et qu'il tient ladite canne par une main par l'intermédiaire de la poignée avec le bras correspondant bien calé dans le repose-bras comme montré à la figure 1, il peut faire réaliser au disque de détection des mouvements de balayage latéraux parallèlement au sol, tout en ayant la possibilité d'intervenir avec son autre main sur la télécommande afin de modifier les réglages du détecteur si besoin.

L'homme du métier appréciera que les modes de mise en œuvre de l'invention ne sont pas limités par la technologie du détecteur de métaux. À titre d'exemple uniquement, et en référence aux technologies exposées dans l'introduction de la description, on considéra ici pour les besoins de la présente description qu'il s'agit d'un détecteur à balance d'induction (IB) fonctionnant en mode CW.

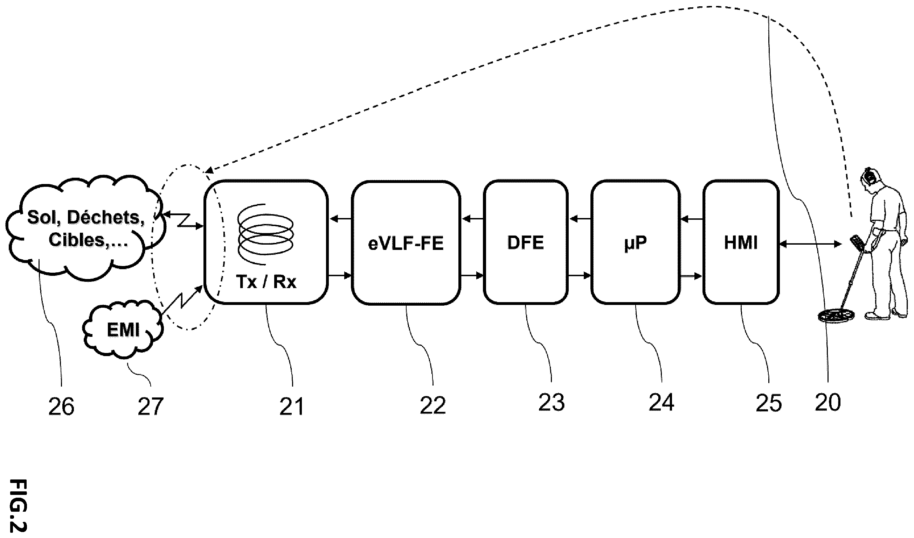

Il est possible de décomposer l'architecture d'un détecteur de métaux de la manière qui va être décrite ci-dessous en référence au schéma fonctionnel de la **figure 2****.** Ce découpage fonctionnel permet de distinguer les principales fonctions assurées par le détecteur, mais n'est pas limitatif de la manière dont ces fonctions sont mises en œuvre au niveau matériel, certaines foncions pouvant être regroupées ou à l'inverse éclatées au sein d'éléments matériels déterminés, lesquels peuvent également mettre en œuvre des fonctions supplémentaires qui ne sont pas considérées ici car elles ne sont pas essentielles pour l'exposé de modes de réalisation de l'invention.

Le détecteur comprend un ensemble d'émission/réception électromagnétique 21, comprenant la (ou les) bobine(s) à savoir au moins une bobine émettrice et au moins une bobine réceptrice, sachant que ces deux bobines peuvent également ne faire qu'une. Cet ensemble 21 est implanté dans la tête de détection 10 de la figure 1.

Le détecteur comprend aussi un module frontal analogique 22 (ou eVLF FE, où "FE" est mis pour *"front end*" en anglais, et où le terme "eVLF" est dérivé du terme "VLF" (de l'anglais "Very Low Frequency") qui désigne la bande de fréquence de 3 kHz à 30 kHz), ainsi qu'un module frontal numérique 23 (ou DFE, mis pour *"Digital front end*" en anglais). L'ensemble de ces deux modules frontaux assure l'émission (Tx) du champ magnétique incident.

Dans le sens de la réception (Rx), les modules frontaux 22 et 23 assurent la transposition des signaux analogiques adaptés aux bobines, en signaux à très basse fréquence (généralement inférieure à 100 Hz) représentatifs du passage de la tête de détection su-dessus de la cible, en appliquant une transposition de fréquence, ce qui peut être réalisé par une démodulation et un filtrage associé. Le plus souvent, le module frontal analogique 22 intègre les amplifications de puissance de la chaîne d'émission (Tx) et les amplificateurs faible bruit des chaînes de réception (Rx). La bande VLF est généralement utilisée mais des fréquences plus basses et des fréquences plus hautes, i.e., des fréquences dans une plage de fréquences plus étendue que la bande VLF, par exemple comprise entre 1kHz et 100 kHz, peuvent également être utilisées pour la détection de métaux lors de recherches spécifiques. C'est pour cela que l'on parle ici de bande VLF "étendue" (notée eVLF), cette expression (et cet acronyme) n'appartenant pas forcément au langage courant de l'homme du métier dans le domaine technique considéré. Le module frontal analogique 22 peut également intégrer les démodulateurs, mais les démodulateurs sont le plus souvent réalisés dans le module frontal numérique 23 pour les détecteurs à bande étroite.

L'homme de métier appréciera, en outre, que la séparation analogique/numérique dépend de la conception de l'équipement, et n'est pas limitée, en pratique, par les exemples considérés ici.

Le dispositif 10 comprend encore un processeur de détection 24, qui est adapté pour appliquer les traitements de détection afin de déterminer la présence et éventuellement le type de cibles métalliques.

En pratique, le processeur de détection 24 peut être implémenté sous la forme d'un circuit électronique miniaturisé, ce qui lui permet, dans certains détecteurs de métaux, de pouvoir être intégré au disque de détection 11 (figure 1). Un tel circuit est adapté pour numériser et analyser les signaux de détection et pour produire les données de détection et les données de discrimination, ces données étant ensuite envoyées en temps réel à l'interface utilisateur 25 (voir plus loin), par exemple par liaison radio numérique comme représenté à la figure 1 ou bien par connexion filaire, pour restitution sonore par le casque audio 13 et éventuellement, en outre, pour affichage au niveau de la télécommande 12.

Les performances du détecteur peuvent être affectées par les différents niveaux de minéralisation du sol qui peuvent être rencontrés selon les cas d'usage. Il peut par exemple s'agir de minéralisations d'origine naturelle de type magnétique : oxyde de fer, ferrites, magnétites. Il peut aussi s'agir de minéralisations ponctuelles liées à d'anciens lieux d'occupation humaine (elles aussi magnétiques), par exemple des foyers, terres cuites, ferrites, scories, etc. Il peut encore s'agir de minéralisations de bords de mer qui pourront aller du grade magnétique (sables noirs) au grade conducteur électrique (eau salée), suivant les plages et les régions. A la figure 2, les perturbations électromagnétiques sont symbolisées par le nuage 26.

La détection est également parasitée par les perturbations électromagnétiques (ou EMI, de l'anglais *"Electromagnetic interference"*) qui sont nombreuses notamment en milieu urbanisé (ligne à haute tension, transformateur électrique, clôture électrique, lignes électriques, relais hertziens, téléphones mobiles, ordinateurs, téléviseurs, autres détecteurs de métaux en marche à proximité, etc...), ainsi que par les pollutions métalliques. A la figure 2, les perturbations électromagnétiques sont symbolisées par le nuage 27.

Enfin le détecteur comprend une interface homme-machine aussi appelée interface utilisateur 25 (ou HMI, mis pour *"Human-Machine Interface",* en anglais). L'interface utilisateur 25 permet de configurer l'équipement, d'une part, et de restituer des informations indiquant la présence éventuelle de cibles métalliques et, possiblement, également des informations relatives à leur identification, ainsi éventuellement que des informations d'aide à la détection permettant d'assister l'utilisateur dans sa recherche, d'autre part. Ainsi qu'il a déjà été indiqué en introduction, la restitution audio est l'interface la plus communément utilisée pour cela, et c'est elle qui fait l'objet de la présente invention. L'interface utilisateur 25 comprend ainsi le casque audio 13 de la figure 1 et/ou tout autre transducteur électroacoustique, par exemple un ou plusieurs haut-parleurs.

Néanmoins, tout ou partie des informations précitées peuvent aussi être restituées sous une autre forme, par exemple sous forme visible par affichage sur un écran. L'interface utilisateur 25 comprend à cet effet la télécommande 12 (figure 1). La télécommande permet aussi à l'utilisateur d'ajuster les principaux réglages de détection comme la sensibilité, la discrimination, les effets de sol, les tonalités, la (ou les) fréquence(s) utilisée(s) pour les signaux émis et traités par la tête de détection, le volume etc... mais aussi de sélectionner des programmes d'usine ou ceux créés au préalable par l'utilisateur lui-même avec la télécommande. Ces réglages modifient la détection, ce qui est symbolisé à la figure 2 par la flèche 20 en traits pointillés.

En résumé, l'interface utilisateur peut être mise en œuvre dans la télécommande 12, et elle comprend aussi le casque audio 13 pour la restitution audio du signal de détection à l'utilisateur, ce dernier pouvant être regardé comme un périphérique dédié à la restitution sous forme sonore du signal de détection. Dans certains modes de réalisation, le casque audio peut également comprendre des boutons ou similaires pour effectuer certains réglages du détecteur, notamment mais pas uniquement des réglages relatifs à la restitution sous forme sonore du signal de détection. En outre, on retiendra que le signal audio qui est généré pour la restitution sonore du signal de détection électromagnétique est dérivé dudit signal de détection reçu sous forme "brute" par la tête de détection par des opérations de démodulation (au sens large) et de dérivation(s) / filtrage(s) pour aboutir à un signal très basse fréquence (avec une fréquence généralement inférieure à une centaine de Hertz) caractéristique.

Le signal de détection électromagnétique (plus simplement appelé ici le "signal") a une amplitude qui varie quand la tête de détection se déplace au-dessus de la cible proportionnellement aux champs produits dans la cible par la circulation des courants de Foucault et reçus par la tête de détection. Pour les petites cibles, l'amplitude du champ magnétique au niveau de la cible est proportionnelle à 1/(a²+d²)^{3/2}, où "a" désigne le diamètre de la tête de détection (et donc sensiblement le diamètre des antennes d'émission et/ou de réception), et où "d" désigne la distance de la tête à la cible. L'amplitude du signal reçu par la tête de réception quand celle-ci balaie une cible à une distance donnée correspond à un aller-retour du signal. Il varie donc approximativement avec une relation de la forme K x 1/(a²+d²)³.

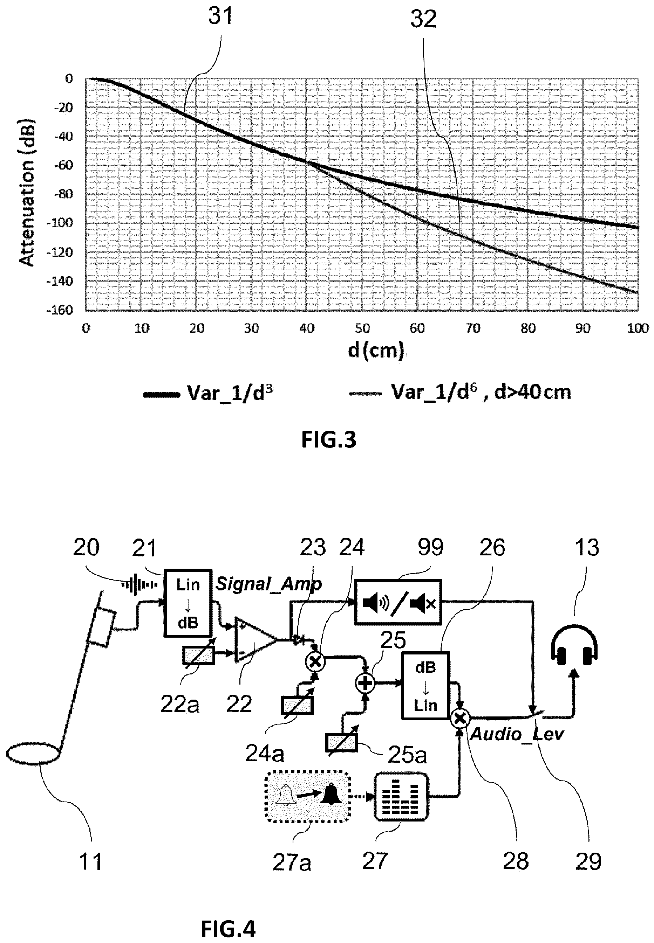

Dans un cas simplifié où la distance "d" de la tête à la cible est importante relativement au diamètre "a" de la tête, les courbes 31 et 32 de la **figure 3** illustrent, respectivement, l'amplitude du champ magnétique au niveau de la cible qui varie en 1/d³ c'est-à-dire sous la forme K x 1/d³, et le signal reçu au niveau de la tête de réception qui varie en 1/d⁶ c'est-à-dire sous la forme K x 1/d⁶, où K est un facteur de proportionnalité dépendant des conditions d'utilisation. Les courbes 31 et 32 correspondent à un exemple de cas d'usage pour une petite cible, dans lequel la tête de détection présente un diamètre de 28 cm (a=28 cm) et dans lequel la distance de référence d₀ (qui donne une atténuation de 0 dB) est sensiblement égale à 1 cm.

Il sera maintenant exposé les caractéristiques qui peuvent servir à présenter à l'utilisateur des informations relatives à la détection d'une cible métallique, et des informations de discrimination permettant audit utilisateur, dans une certaine mesure, d'identifier cette cible.

La réactivité est un paramètre qui conditionne le comportement du détecteur en termes de vitesse d'analyse et de sélectivité. La sélectivité s'entend du pouvoir de séparation entre les cibles. Si un sol est pollué de matériaux ferreux, de ferrites ou d'autres débris minéralisés (ci-après "polluants", la pénétration du sol est en général réduite et la capacité d'un détecteur à repérer des cibles proches de ferreux l'est également. Dans ces conditions, il est possible de choisir un niveau de réactivité élevé qui permet d'accélérer l'analyse des signaux. Au contraire, si le terrain est propre c'est-à-dire relativement exempt de polluants, il peut être approprié de ralentir la réactivité et le balayage, afin d'être plus sensible aux masses profondes et pénétrer davantage dans le sol. Ajuster le paramètre "réactivité" du détecteur permet donc de rendre le détecteur plus ou moins rapide et sélectif.

En fonction de la réactivité, la durée du signal audio varie au passage d'une cible sous la tête de détection en mouvement : avec une réactivité relativement plus basse, une cible donne un son relativement plus long et, *vice versa,* avec une réactivité relativement plus haute, la même cible donne un son relativement plus court. On notera que la durée du son des faux signaux (correspondants à des craquements des ferreux par exemple), varie aussi en proportion, i.e., varie de la même façon que la durée d'un signal cible en fonction de la réactivité.

Il y a essentiellement trois caractéristiques à considérer dans un son :
- la hauteur du son, qui détermine son degré d'élévation entre ce qui est ressenti (par l'être humain) comme grave et ce qui est ressenti comme aigu ;
- l'intensité du son, qui différentie un son fort d'un son faible ; et,
- le timbre du son, qui permet de distinguer un son "agressif" d'un son "doux".

Par ailleurs, un son est dit "pur" lorsque l'onde sonore est parfaitement sinusoïdale.

La hauteur d'un son pur correspond à sa fréquence de vibration, que l'on mesure en hertz (nombre de vibrations périodiques par seconde). Plus la vibration est rapide, plus le son est dit haut ou aigu. Inversement, plus la vibration est lente, plus le son est dit bas ou grave. Les fréquences audibles par l'être humain s'étendent de 20 Hz à 20 000 Hz (20 kH). Un son est généralement considéré comme aigu lorsque sa fréquence fondamentale est supérieure (environ) à 2 000 Hz (2kHz). Il est considéré comme grave lorsque sa fréquence fondamentale est inférieure à 200 Hz. Dans la nature, toutefois, un son n'est presque jamais pur, c'est-à-dire qu'il est formé de plusieurs sons de fréquences respectives différentes. En outre, les différences de timbre d'un son résultent principalement de la combinaison des différentes harmoniques d'un son, avec différentes intensités respectives. Le timbre dépend donc principalement du spectre en fréquence du son, ainsi qu'il est explicité plus bas.

L'intensité d'un son est une grandeur qui permet de donner une indication sur la "force" du son : plus l'intensité sonore est élevée et plus le son perçu par l'oreille humaine est fort. L'intensité sonore se note avec la lettre "I" et s'exprime en watt par mètre carré (W.m⁻²). Cette unité indique qu'elle correspond à un "débit" d'énergie par unité de surface. L'oreille humaine peut en moyenne percevoir des sons ayant une intensité sonore supérieure à une valeur de l'ordre de 10⁻¹² W.m⁻². Cette intensité sonore minimale est appelée seuil d'audibilité "I₀". Un son dont l'intensité sonore est très élevée peut provoquer une douleur chez l'être humain, ainsi qu'une perte d'audition partielle ou totale. On estime en général que le seuil de douleur chez un individu normal correspond à une valeur d'environ 10 W.m⁻² qui correspond à 130 dB SPL, sachant que la valeur sur une échelle en décibels d'une intensité sonore I est donnée par 10 x log(I/I₀). Par ailleurs, l'exposition répétée à des ondes sonores d'intensités élevées mais inférieures aux intensités maximales, sans protections appropriées, peut également engendrer des dommages sur l'oreille humaine.

Le timbre d'un son désigne l'ensemble des caractéristiques particulières qui permettent de distinguer deux sons ayant la même fréquence fondamentale et la même intensité mais qui ne donnent pas les mêmes sensations physiologiques. Par exemple une même note de musique, comme le "Do", procure un ressenti spécifique selon qu'elle est jouée par des instruments de musique différents bien qu'ils produisent alors des sons de même fréquence fondamentale et possiblement de même intensité. Le timbre d'un son est donc indépendant de sa hauteur et de son intensité. Dans la nature, il est spécifique de l'instrument ou de la voix qui l'émet. Physiquement, il est lié au nombre et aux intensités relatives des harmoniques qui composent le son.

On notera que le ressenti dépend aussi de la forme du son, c'est-à-dire de la forme d'ondes des différentes vibrations qui le composent, laquelle est liée aux transitoires d'attaque, aux transitoires d'extinction, et au corps du son c'est-à-dire à ses propriétés entre les transitoires d'attaque et d'extinction. L'attaque d'un son peut être relativement lente ou relativement rapide, et relativement progressive ou relativement brutale. Le corps d'un son peut quant à lui être relativement régulier ou avec des pics, sensiblement sinusoïdal ou plus complexe, et avec plus ou moins d'amplitude. On distingue ainsi, classiquement, un son doux d'un son aigre (ou agressif) même lorsqu'ils ont sensiblement la même hauteur et la même intensité.

Afin de pallier les inconvénients de la technique qui ont été présentés en introduction, des modes de réalisation de l'invention proposent un procédé et un dispositif permettant de modifier la plage dynamique du signal audio associé à la cible qui est restitué à l'utilisateur, de manière à rendre cette dynamique compatible avec la dynamique réellement utilisable par le système auditif humain, tout permettant une dissociation entre la variation de niveau ressenti et le contenu spectral du signal audio.

Selon des modes de réalisation, cette modification de la plage dynamique s'opère, pour l'implémentation la plus simple, par une réduction de celle-ci obtenue par le procédé et le dispositif illustré par le diagramme fonctionnel de **la** **figure 4****.** Ce diagramme est purement schématique, et les éléments de ce schéma-blocs symbolisent tant les étapes du procédé de restitution sonore selon des modes de mise en œuvre du procédé que les moyens fonctionnels d'un dispositif pour cette mise en œuvre. Dit autrement, le schéma de la figure 4 illustre la chaîne de traitement du signal de détection qui conduit à la production d'un signal audio *Audio_Lev* dont la hauteur, l'intensité et le timbre sont générés de manière à restituer de manière sonore, audible de manière confortable par l'utilisateur, toute la dynamique d'amplitude du signal de détection de la cible ainsi, le cas échéant, que des informations de discrimination associées lorsque de telles informations sont également disponibles.

En référence à la figure 4, le signal 20 de détection de la cible, issu d'un traitement (non représenté) destiné à isoler celui-ci du bruit, est acheminé vers un module de linéarisation 21 qui est adapté pour effectuer une conversion du signal de détection en décibels (dB). Cela permet d'obtenir un signal *Signal_Amp* dont l'amplitude varie approximativement linéairement en fonction de la distance d de la cible à la tête de détection. Dans un mode de réalisation, le dispositif de linéarisation 21 peut être un simple amplificateur logarithmique. Il va sans dire que d'autres procédés de linéarisation peuvent être envisagés.

Un amplificateur logarithmique peut être réalisé en composants électroniques analogiques. De manière connue en soi, un amplificateur logarithmique analogique est un amplificateur non linéaire qui produit une sortie représentant le logarithme du signal d'entrée.

En variante, l'amplificateur logarithmique 21 peut aussi être réalisé par traitement numérique, par interpolation linéaire ou polynomiale, par exemple.

Le seuil de détection du détecteur de métaux est ensuite soustrait du signal linéarisé *Signal_Amp.* Cette opération de soustraction est ici symbolisée par un soustracteur 22, dont l'entrée positive "+" reçoit le signal linéarisé *Signal_Amp* et dont l'entrée négative "-" reçoit une valeur représentative du seuil de détection. Dans certains modes de réalisation, comme représenté à la figure 4, cette valeur est générée par un module d'adaptation de seuil qui permet de faire varier le seuil de détection du détecteur de métaux. Cette variation peut être commandée "à la demande" par l'utilisateur à l'aide de la télécommande du détecteur, en fonction de son ressenti et/ou de sa stratégie de recherche de métaux. Elle peut aussi résulter de la mise en œuvre d'un programme préenregistré particulier.

Dans un mode de réalisation, le signal résultant de l'opération de soustraction précitée peut ensuite subir un redressement simple alternance, symbolisé à la figure 4 par le symbole d'une diode 23. L'homme du métier appréciera que les valeurs négatives du signal en sortie du soustracteur 22 correspondent à des niveaux du signal *Signal_Amp* qui sont inférieurs au seuil de détection du détecteur. En d'autres termes, les éventuelles valeurs négatives de la dynamique du signal de détection après soustraction de la valeur du seuil d'audibilité sont éliminées par le filtrage opéré par le redresseur 23. On s'assure ainsi d'avoir une valeur minimale égale à zéro en entrée de la partie avale de la chaîne de traitement.

La valeur du signal en sortie du redresseur 23 varie donc de 0 dB si le signal cible est égal audit seuil, à la valeur maximale de la plage dynamique entre le seuil et l'amplitude maximale (en décibels) du signal de détection, c'est-à-dire potentiellement plus de 100 dB comme il a été exposé en introduction de la présente description.

Conformément à l'enseignement des modes de réalisation de l'invention, cet écart par rapport au seuil est à son tour multiplié par le taux de compression de la dynamique désiré. Celui-ci est égal à l'unité (c'est-à-dire à 1) pour une absence de compression. Pour obtenir une compression, il est strictement compris entre 0 et 1.

Le taux de compression de la dynamique est typiquement égal à une valeur comprise entre 0.2 et 0.5 pour réduire une dynamique de variation de 0 à 100 dB à une dynamique de variation de 0 à 30 dB, par exemple. A la figure 4, cette opération de compression est représentée par un multiplicateur, ou opérateur de multiplication 24, recevant le signal le signal en sortie du redresseur 23 sur une première entrée, et recevant une valeur représentative du taux de compression sur une seconde entrée. Dans certains modes de réalisation, comme représenté à la figure 4, cette valeur peut être fournie par un module d'adaptation de compression 24a qui permet de faire varier le taux de compression de la dynamique.

Une valeur représentative du seuil d'audibilité "I₀" est ensuite ajoutée, laquelle correspond à l'intensité minimale souhaitée du signal audio c'est-à-dire le son le plus faible restitué à l'utilisateur (*"baseline"*)*.* A la figure 4, cette addition est symbolisée par un additionneur, ou opérateur d'addition 25, qui reçoit le signal en sortie du multiplicateur 24 sur une première entrée, et qui reçoit la valeur représentative du seuil d'audibilité "I₀" sur une seconde entrée. Dans certains modes de réalisation, comme représenté à la figure 4, cette valeur est fournie par un module 25a d'adaptation du seuil d'audibilité. Ce seuil peut en effet être variable, afin de pouvoir être adapté à la perception acoustique propre à chaque utilisateur.

Dans un exemple, le signal en sortie de l'additionneur 25 peut varier avec une dynamique souhaitable, c'est-à-dire dans un intervalle idéal, compris par exemple entre 20 dB et 50 dB.

Dans certains modes de réalisation, on peut alors procéder à l'opération inverse de la linéarisation opérée par le module de linéarisation 21. Dit autrement, le signal est converti de valeurs en décibels vers des valeurs linéaires. Cette opération peut par exemple être réalisée par une fonction exponentielle, avec un gain adéquat.

La sortie du module de conversion 26 module en amplitude un signal audio produit par un générateur de sons 27, qui est utilisé pour générer les sons associés à la détection d'une cible déterminée. Plus particulièrement, le générateur de sons 27 est adapté pour produire des sons avec une hauteur (fréquence) qui est fonction, par exemple, de la distance entre la tête de détection et la cible détectée. Comme on l'aura compris, le dispositif selon des modes de réalisation de l'invention qui est représenté à la figure 4 a pour unique fonction d'adapter la dynamique de l'intensité (volume) du son délivré en sortie, à la dynamique du signal de détection reçu en entrée.

La fonction précitée de modulation de l'amplitude du signal audio généré par le générateur 26 par le signal en sortie du module de conversion 26 est symbolisée, à la figure 4, par un multiplicateur ou opérateur de multiplication 28. Celui-ci reçoit sur une première entrée le signal délivré par le générateur de son 27 (signal modulé), et reçoit sur une seconde entrée le signal en sortie du module de conversion 26 -signal modulant). Le multiplicateur délivre le signal de sortie du dispositif, à savoir un signal audio *Audio_Lev* avec des variations correspondant à celles de l'amplitude du signal d'entrée 20, mais à l'intérieur de l'intervalle d'intensité sonore désiré, c'est-à-à-dire la dynamique désirée du signal audio.

Dans certains modes de réalisation, le générateur de signal audio 27 peut en outre recevoir des informations d'un module de variation de timbre 27, permettant de faire varier le timbre du signal audio de sortie en fonction des informations de discrimination générées par le détecteur de métaux, ainsi qu'il a été présenté en introduction.

L'homme du métier appréciera que la conversion finale d'une échelle logarithmique (échelle en décibels) à une échelle linéaire opérée par le module de conversion 26 n'est pas obligatoirement nécessaire. En effet, certains dispositifs, comme des convertisseurs analogique-numériques (DAC) ou des amplificateurs audios, peuvent recevoir en entrée directement les informations en décibels.

En outre, dans certains modes de réalisation, un circuit 99 de coupure du son (ou "mute") peut être disposé en sortie du module de soustraction 22 du seuil de détection. Ce module permet de détecter si le signal est en-dessous du niveau de seuil et de commander si besoin (par exemple en fonction du mode audio choisi par l'utilisateur) un "mute" du signal audio pour les signaux en dessous du seuil de détection. Cette fonction "mute" est ici symbolisée par un interrupteur commandé 29 fonctionnant en tout ou rien, disposé entre la sortie du modulateur 26 et le casque audio 13, et commandé par le circuit 99. On notera qu'un "mute" peut aussi être généré, de la même manière, dans le cas de la détection de cibles d'un certain type particulier ou de plusieurs types particuliers, afin de ne pas alerter inutilement l'utilisateur si la cible détectée ne correspond pas au type de cible recherché.

Enfin, l'homme du métier appréciera qu'un réglage du gain audio global de la chaîne de traitement de la figure 4, non représenté ici, peut être intégré à la chaine de traitement. En variante, il peut être implémenté sous la forme d'un réglage de volume associé au casque audio 13. Ce dernier peut bien sûr être remplacé par un haut-parleur sans que cela ne change le fondement de l'invention. Le réglage du gain ne fait pas partie, en soi, du présent exposé dans la mesure où l'invention concerne la dynamique du signal audio en sortie pour restituer de manière satisfaisante toute la dynamique du signal de détection en entrée.

En résumé, l'invention permet d'effectuer une compression de la dynamique du signal de détection de la cible afin de correspondre à la dynamique désirée du signal audio qui est généré pour restituer ce signal de détection de manière sonore, la dynamique s'entendant ici comme étant la différence entre deux valeurs extrêmes. S'agissant du signal de détection, la dynamique s'entend plus particulièrement de la plage de valeurs d'amplitude du signal qui est comprise entre une extrémité inférieure et une extrémité supérieure. Pour le signal audio restitué à l'utilisateur, la dynamique représente le rapport entre le son le plus fort (ayant l'intensité sonore la plus élevée) et le son le plus faible (ayant l'intensité sonore la moins élevée). L'invention permet, dans le contexte de la détection de métaux, d'éviter la perte de signal de détection à l'extrémité inférieure et la limitation ou l'écrêtage à l'extrémité supérieure de la plage de variation d'amplitude du signal de détection, dans le signal audio correspondant qui est généré afin de restituer à l'utilisateur ce signal de détection de manière sonore.

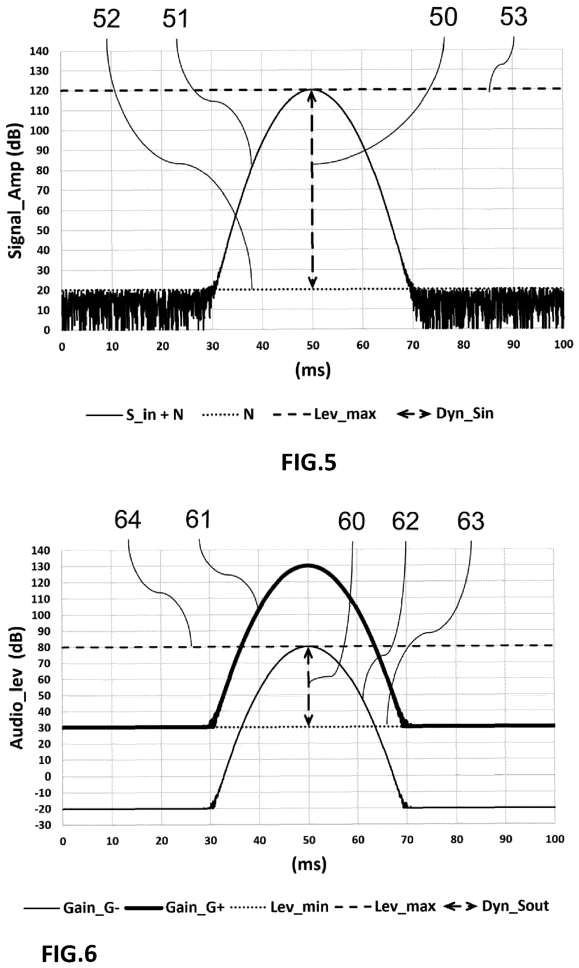

Cet effet technique va maintenant être explicité en référence aux graphes des figures 5 à 9.

La **figure 5****,** tout d'abord, montre l'évolution de l'amplitude, en fonction du temps, d'un exemple de signal électromagnétique de détection d'une cible. Dans cet exemple une cible métallique est détectée à l'intérieur d'une fenêtre de temps (fenêtre temporelle) d'une largeur égale à 40 ms, entre les instants t=30 ms et t=70 ms, portée en abscisses. La portion de signal représentée à la figure est issue de la tête de détection d'un détecteur de métaux lors d'un unique mouvement de balayage de la tête de détection au-dessus d'une cible métallique. Plus particulièrement, sur la figure 5 le signal de détection est représenté en ordonnées sur une échelle logarithmique. Il s'agit par exemple de la version *Signal_Amp* du signal de détection prise en sortie du module de linéarisation 21 de la figure 4. Sur cette échelle, la courbe 51 représentant le signal a une forme en cloche : la partie montante correspond au rapprochement la tête de détection vers la cible, le sommet de la gaussienne correspondant au moment (à l'instant t=50 ms dans l'exemple) où la tête est la plus proche de la cible et la partie descendante de la gaussienne correspondant à l'éloignement la tête de détection à partir de la cible.

En fait, la courbe 51 correspond au signal de détection utile S_in mélangé à du bruit de détection qui provient des différents perturbateurs illustrés symboliquement à la figure 2 par les nuages 26 et 27. Le niveau maximum du bruit N est représenté par la droite horizontale 52 en trait pointillé. L'amplitude maximale du signal bruité (S_in + N) est représentée par la droite horizontale 53 en trait discontinu. Comme on le voit, la dynamique Dyn_Sin du signal de détection utile (signal non bruité S_in), ici représentée par la flèche verticale 50 en trait discontinu, correspond à une plage de valeurs d'amplitude qui s'étend, sur l'échelle logarithmique représentée, entre les valeurs minimales et maximales du signal bruité S_in+N qui sont égales à 20 dB et 120 dB, respectivement. Cette dynamique 50 est donc égale à 100 dB.

La **figure 6** donne des graphes d'un exemple de signal audio pour la restitution sonore du signal de la figure 4 selon une méthode à dynamique constante, dans laquelle on se contenterait de faire varier le gain de la chaîne de traitement du signal de détection à restituer générant le signal audio correspondant. Plus particulièrement, les graphes 61 et 62 correspondent à des valeurs du gain maximale G+ et minimale G-, respectivement, qui seraient choisies de la manière suivante :
- le gain serait réglé sur la valeur maximale G+ de manière que tout le signal audio se situe environ 10 dB(A) au-dessus du niveau du bruit acoustique ambiant (lequel peut être estimé au minimum à 30 dB(A) comme exposé en introduction, mais est atténué du fait de l'utilisation d'un casque audio d'une valeur qu'on peut estimer égale à 10 dB) afin de pouvoir être distingué de ce bruit ; alors que ;
- le gain serait réglé sur la valeur minimale G- de manière que tout le signal audio se situe au-dessous du niveau limite imposé par la réglementation (établi à 80 dB(A) comme exposé en introduction).

On appréciera que la restitution de la dynamique 50 de l'amplitude du signal de détection de la figure 5 donne, dans le cas du gain G+ correspondant à la courbe 61, des valeurs du signal audio pouvant atteindre 130 dB SPL (A), donc largement supérieures au seuil maximum de confort auditif Lev_max de 80 dB SPL (A) représenté par la droite horizontale 64 en trait discontinu, ce qui n'est pas tolérable et nécessite donc d'écrêter le signal audio à hauteur de ce seuil afin de protéger l'appareil auditif de l'utilisateur. Inversement, dans le cas du gain G- correspondant à la courbe 62, le signal audio restituant toute la dynamique du signal de détection (qui est de 100 dB) peut descendre à des valeurs du signal audio largement au-dessous du seuil d'audibilité Lev_min représenté par la droite horizontale 63 en trait pointillé, c'est-à-dire en dessous de 30 dB SPL (A) en tenant compte du bruit. Dans ce cas, les variations correspondantes du signal de détection sont perdues dans le signal audio qui est restitué à l'utilisateur.

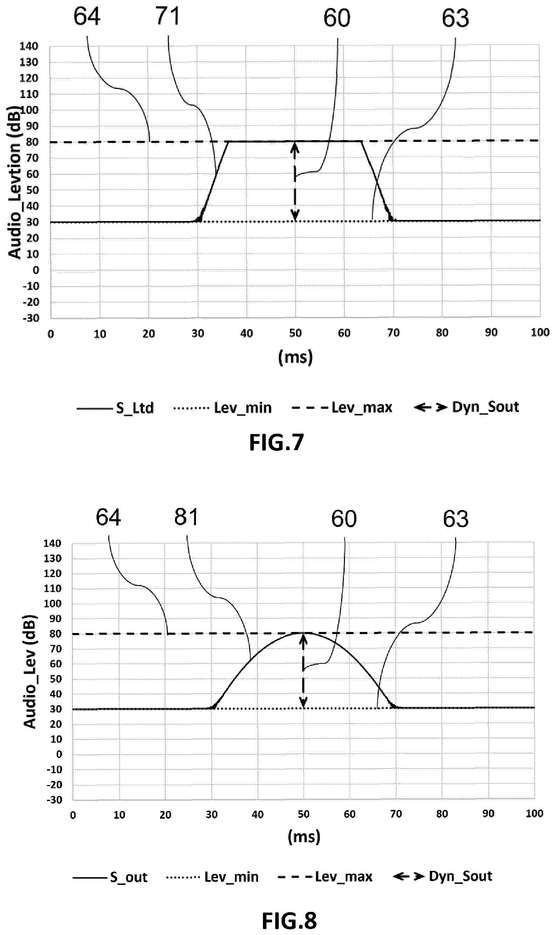

L'effet combiné de la limitation de la dynamique Dyn_Sout résultant de l'écrêtage par le haut et de la perte par le bas des variations d'amplitudes du signal de détection est illustré graphiquement par la courbe 70 de la **figure 7****.** Cette courbe représente l'évolution, en fonction du temps et pour une valeur déterminée du gain de la chaîne de restitution, du signal audio S_Ltd qui est limité par les deux phénomènes présentés ci-dessus. Comme on le voit, la dynamique Dyn_Sout du signal audio qui restitue le signal de détection à l'utilisateur est avantageusement comprise dans la plage de valeurs confortables, entre 20 dB SPL (A) et 80 dB SPL (A) correspondant à un signal qui est à la fois audible compte tenu du bruit ambiant et respectueux de l'intégrité de l'appareil auditif de l'utilisateur.

L'homme du métier appréciera que toute valeur du gain G de la chaîne de traitement comprise entre la valeur minimal G- et la valeur maximale G+ présentées ci-dessus en référence aux graphes de la figure 6, présente plus ou moins, à des degrés respectifs pondérés relativement entre eux, les inconvénients mentionnés dans ce qui précède à propos de la courbe 62 et de la courbe 61, respectivement. Plus le gain G est élevé entre les valeurs G-et G+, et plus on privilégie la restitution sonore de la variation des valeurs d'amplitude basses du signal de détection, au détriment de la restitution de la variation des valeurs d'amplitude hautes qui sont supprimées par écrêtage du signal audio. Inversement, plus le gain G est bas entre les valeurs G- et G+, et plus on privilégie la restitution sonore de la variation des valeurs d'amplitude hautes du signal de détection, au détriment de la restitution de la variation des valeurs d'amplitude basses qui sont perdues dans le signal audio dans la mesure où elles ne sont pas audibles par l'utilisateur.

En d'autres termes, l'utilisateur peut certes faire varier le gain linéairement pour l'intégralité de la plage d'amplitudes du signal de détection afin de privilégier la restitution sonore des amplitudes basses ou celle des amplitudes hautes du signal de détection, mais dans tous les cas la dynamique utile Dyn_Sout du signal audio représentée à la figure 6 par la flèche verticale 60 en trait discontinu ne restitue que très imparfaitement la dynamique Dyn_Sin du signal de détection de la cible (voir flèche 50 à la figure 5). Dit autrement, encore, la variation du gain de la chaîne de traitement effectuée linéairement dans l'intégralité de la plage de variation du signal de détection ne permet ni plus ni moins que de trouver un compromis entre la perte des variations du signal de détection à l'extrémité inférieure de la plage d'amplitudes d'une part, et la limitation par écrêtage du signal audio à l'extrémité supérieure de la plage d'amplitudes, d'autre part, dans le signal audio correspondant qui est généré afin de restituer à l'utilisateur ce signal de détection de manière sonore.

Inversement, le signal audio généré conformément à des modes de réalisation en utilisant la technique de compression de la dynamique Dyn_Sin du signal de détection fourni en entrée, avec un taux de compression adapté pour correspondre à la dynamique utile Dyn_Sout du signal de sortie, qui est représenté par le graphe 81 de la **figure 8****,** respecte les variations de l'amplitude du signal de détection. Ceci se voit à ce que la courbe 81 de la figure 8 correspond à la courbe 51 de la figure 5, en étant "ramassée" c'est-à-dire compressée dans l'intervalle de valeurs (sur l'échelle en décibels) compris entre 30 dB SPL (A) et 80 dB SPL (A).

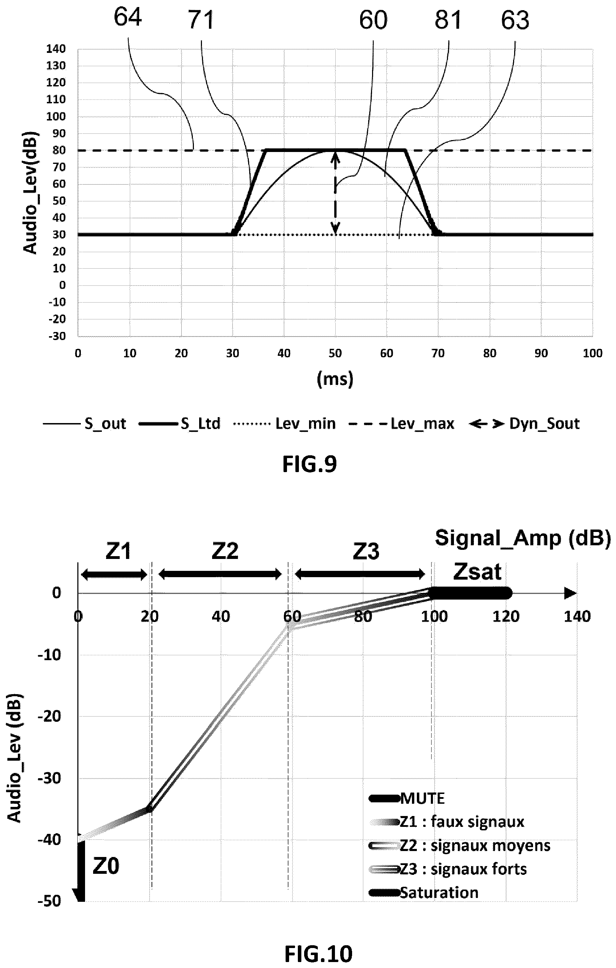

Afin de faciliter la comparaison, la courbe 71 de la figure 7 et la courbe 81 de la figure 8 sont superposées à la **figure 9****.**

Dans un mode de mise en œuvre illustré par le graphe de la **figure 10****,** le signal de détection de la cible est segmenté de manière à définir plusieurs portions ou zones dans lesquelles on peut avoir des taux de compression associés, appelés taux de compression locale de dynamique, qui peuvent être différents d'une zone à l'autre. Le graphe montre, en ordonnées, le niveau du signal audio en décibels (dB), noté "Audio_Lev" en fonction de l'amplitude (en dB) du signal de détection de la cible noté "Signal_Amp" et représentée en abscisses. Dans la figure 10, le niveau de référence donnant 0 dB correspond au niveau maximum qui est confortable pour l'utilisateur, et que l'utilisateur peut régler avec le réglage de volume. Par ailleurs, dans l'exemple représenté la dynamique Dyn_Sout du signal audio est ici de 40 dB, comprise entre - 40 dB et 0 dB.

Dans le mode de mise en œuvre montré à la figure 10, le signal de détection est segmenté en trois portions ou zones, respectivement Z1, Z2 et Z3, correspondant à des intervalles respectifs de sa dynamique, par exemple des zones contigües deux-à-deux. Ceci n'est toutefois pas limitatif. Notamment, l'homme du métier appréciera que la dynamique du signal de détection de la cible peut être subdivisée en deux portions seulement, ou inversement en quatre portions ou plus.

Dans l'exemple considéré ici, la première portion correspond à la zone dite des "faux signaux" qui correspond (par exemple) à une plage dynamique de 10 à 20 dB au-dessus du seuil de détection. Une deuxième portion Z2 correspond à la zone des signaux dits "signaux moyens", de la fin de la zone Z1 jusqu'à par exemple 60dB au-dessus du seuil de détection, suivie de la portion Z3 correspondant à la zone des signaux forts, après 60 dB au-dessus dudit seuil. Les portions de la dynamique correspondant à la première et la dernière zone, Z1 et Z3 respectivement, peuvent être ainsi modifiées par des taux de compression locale de dynamique plus faibles que celui qui est appliqué à la portion de la dynamique correspondant à la zone Z2, dans le but, par exemple, de magnifier les signaux cibles dans la zone Z2 des signaux moyens.

On notera qu'il y a en fait deux zones supplémentaires implicites : la première est la zone Z0 de la dynamique qui est en dessous du seuil de détection qui peut correspondre à un "mute" du signal audio restitué ; et la seconde est la zone Zsat de saturation électrique (ou numérique) qui correspond aux niveaux les plus élevés de la dynamique du signal de détection. Pour des raisons qui ont trait à la simplicité de réalisation, les différentes zones peuvent être définies par des segments linéaires. On peut aussi utiliser un lissage pour gommer les ruptures de pente aux "frontières" entre deux zones contigües, par exemple avec un lissage de type Spline.

On appréciera que la compression globale de dynamique qui est recherchée n'interdit pas que au moins un taux de modification locale de dynamique soit supérieur ou égal à l'unité. Dit autrement, une ou plusieurs zones de la dynamique du signal de détection peuvent être localement étendues (on parle alors d'extension ou d'expansion de dynamique, au lieu de compression de dynamique), bien que la dynamique soit compressée globalement, c'est-à-dire si l'on considère globalement l'intégralité de cette dynamique.

Dans un mode de réalisation encore amélioré de l'invention, certaines portions au moins de la dynamique peuvent être associées à des timbres respectifs du signal audio. Par exemple, chaque zone parmi les zones Z1, Z2, Z3 et Zsat peut être associée à un timbre différent. En outre, le changement de timbre peut se faire graduellement au passage d'une portion à l'autre de la dynamique. Dit autrement, le changement de timbre du signal acoustique entre deux portions contigües de la dynamique du signal de détection est progressif de l'une à l'autre.

L'homme du métier appréciera que les changements de timbre du signal acoustique généré par le générateur 27 qui ont été présentés ci-dessus se retrouvent dans le signal audio qui est restitué à l'utilisateur. Ainsi, ces différents modes de mise en œuvre procurent un enrichissement spectral sélectif (c'est-à-dire qui est fonction du niveau du signal) qui améliore la perception sonore, par l'utilisateur, des sons générés pour restituer le signal de détection de la cible métallique.

La segmentation décrite ci-dessus permet en outre d'appliquer les enrichissements spectraux associés aux procédés de discrimination de cible de manière différenciée, suivant le niveau du signal reçu et donc suivant la zone de la dynamique dans laquelle il se trouve, étant observé que la précision de la discrimination des cibles est généralement dégradée pour les signaux faibles et pour les signaux saturés. Plusieurs implémentations peuvent être considérées, qui sont précisées dans ce qui suit.

Dans la première implémentation, l'oscillateur qui génère le son final procède par lecture de table d'onde. Chaque frontière de zone est associée à une forme d'onde préalablement calculée, par exemple en fonction d'un contenu spectral souhaité. L'oscillateur qui génère le son effectue une interpolation entre les deux formes d'ondes définies à la frontière de la zone activée. On peut ainsi, par exemple, réserver à la zone Z1 des "faux signaux" (zone des signaux les plus faibles, perdus dans le bruit) une forme d'onde dont le spectre est relativement "doux" et réserver une forme d'onde au spectre plus "agressif" pour les signaux dans la zone Z3 de la dynamique dont l'amplitude est la plus élevée. De manière similaire, on peut utiliser, pour les signaux les plus forts des formes d'ondes rappelant le spectre de signaux saturés. L'avantage de la modification spectrale variable en fonction du niveau est de permettre à l'oreille de l'utilisateur d'améliorer la perception de niveau, sans avoir recours à une variation de fréquence en fonction du niveau, ce qui permet de réserver la possibilité d'utiliser une variation de fréquence en lien avec des informations de discrimination. La lecture de forme d'onde permet de générer des sons variés, et même, avec un seul oscillateur, de simuler des accords de tierce ou de quinte en générant des tables de formes d'onde dont les composantes fondamentales sont calées sur les harmoniques 4, 5, 6 du signal.

Dans une deuxième implémentation, le changement spectral à l'intérieur d'une zone peut être obtenu par la soustraction de deux formes d'ondes dont la phase dépend du niveau du signal de détection en entrée du dispositif. Ce mode de synthèse permet la génération de signaux de type impulsions de largeurs variables (modulation de largeur d'impulsion ou PWM) en soustrayant deux signaux de type "dent de scie" (ou SAW, de l'anglais *"Sawtooth"*)*.* On peut ainsi générer des signaux dont le contenu spectral varie radicalement suivant la valeur de déphasage, d'un spectre pratiquement "plat" pour des rapports cycliques faibles, à un signal "carré" (spectre avec une décroissance en 1/f, sans harmoniques impaires) pour un rapport cyclique de 50% (voir les spectres associés aux signaux PWM plus haut). Un avantage de ce type de synthèse est qu'il permet de générer des signaux similaires à des signaux PWM (avec des glissements spectraux reconnaissables) tout en ayant le contrôle de la richesse globale du spectre en agissant sur les signaux de base (initialement signaux "en dents de scie") utilisés pour la soustraction.

Dans une troisième implémentation, le changement spectral à l'intérieur d'une zone peut être obtenu par des modulations de fréquence de l'oscillateur utilisé pour la génération de son, en utilisant les méthodes élaborées par John Chowning en 1967.

Dans une quatrième implémentation, le changement spectral à l'intérieur d'une zone peut être obtenu par synthèse soustractive, par exemple en insérant dans le cheminement du signal audio un filtre dont on fait varier dynamiquement les caractéristiques.

Dans une cinquième implémentation, les changements spectraux peuvent être obtenus par synthèse additive, par exemple en mettant en œuvre de multiples oscillateurs audio dont le mélange peut être déterminé en fonction du spectre fréquentiel désiré.

Tout ou partie des implémentations données ci-dessus à titre d'exemple peuvent également être combinées entre elles, de manière à obtenir un enrichissement spectral qui soit plus complexe afin de mieux répondre à des cas d'usage particuliers.

## Revendications

1. Procédé de génération d'un signal audio pour la restitution sonore à l'utilisateur d'un appareil de détection de métaux (10) portatif, à l'aide d'au moins un transducteur électroacoustique, d'un signal de détection électromagnétique d'une cible dont l'amplitude peut varier avec une dynamique déterminée, le procédé comprenant les étapes suivantes :
- réduction de la dynamique du signal de détection afin qu'elle corresponde à une dynamique désirée du signal audio ; et,
- génération (27,28) du signal audio en fonction du signal de détection avec la dynamique réduite,
dans lequel:
- la réduction de la dynamique du signal de détection comprend :
- - l'écrêtage (22) du signal de détection en fonction d'un seuil de détection déterminé ; l'écrêtage (22) du signal de détection comprenant l'écrêtage dudit signal en-dessous du seuil de détection ;
- - l'application (24) au signal de détection écrêté d'un taux de compression globale de dynamique déterminé, qui est fonction du rapport entre la dynamique du signal de détection et la dynamique désirée du signal audio ; et,
- - le décalage (25) du signal de détection compressé pour régler un niveau minimal désiré du signal audio ; et
**caractérisé en ce que**:
le taux de compression globale de dynamique déterminé est strictement compris entre 0 et 1; et
- l'application (24) au signal de détection écrêté du taux de compression globale de dynamique comprend la segmentation de la dynamique du signal de détection en une pluralité de portions (Z1,Z2,Z3) distinctes, ainsi que l'application à des portions différentes du signal de détection écrêté de taux de modification locale de dynamique respectifs.

2. Procédé selon la revendication 1, dans lequel des portions de la dynamique du signal de détection sont définies par des segments linéaires.

3. Procédé selon l'une quelconque des revendications 1 et 2, dans lequel au moins un taux de modification locale de dynamique est supérieur ou égal à l'unité.

4. Procédé selon l'une quelconque des revendications 1 à 3, comprenant en outre, avant l'étape de réduction de la dynamique du signal de détection, une conversion logarithmique (21) dudit signal de détection suivant une échelle logarithmique,
et dans lequel l'application (24) du taux de compression globale de dynamique au signal de détection écrêté ou l'application d'un taux de modification locale de dynamique à une portion déterminée du signal de détection écrêté, comprend la multiplication dudit signal de détection écrêté ou de ladite portion du signal de détection écrêté, respectivement, par ledit taux de compression globale de dynamique ou par ledit taux de modification locale de dynamique, respectivement.

5. Procédé la revendication 4, comprenant en outre, après la réduction de la dynamique du signal de détection et avant la génération du signal audio, une conversion (26) inverse de la conversion logarithmique du signal de détection reçu afin de ramener la dynamique du signal de détection compressé et décalé sur une échelle linéaire.

6. Procédé selon l'une quelconque des revendications 4 ou 5, dans lequel le décalage (25) du signal de détection compressé comprend l'ajout d'une valeur correspondant à un niveau minimal désiré du signal audio.

7. Procédé selon l'une quelconque des revendications 1 à 6, dans lequel le seuil de détection et/ou la valeur correspondant au niveau minimal désiré du signal audio sont programmables (22a,25a).

8. Procédé selon l'une quelconque des revendications 1 à 7, dans lequel la génération du signal audio comprend la génération (27) d'un signal acoustique ayant une composante fondamentale de hauteur déterminée, ainsi que la modulation (28) dudit signal acoustique par le signal de détection compressé et décalé.

9. Procédé selon l'une quelconque des revendications 2 à 8, dans lequel la génération du signal audio comprend en outre un changement de timbre (27a) du signal acoustique, entre deux portions respectives de la dynamique du signal de détection.

10. Procédé selon la revendication 9 dans lequel le changement de timbre du signal acoustique entre deux portions contigües de la dynamique du signal de détection est progressif de l'une à l'autre.

11. Procédé selon l'une quelconque des revendications 1 à 10, dans lequel la réduction de la dynamique du signal de détection reçu comprend en outre, après l'écrêtage (22) du signal de détection mais avant l'application (24) au signal de détection écrêté du taux de compression globale de dynamique, un redressement simple alternance (23) dudit signal de détection écrêté.

12. Produit programme d'ordinateur comprenant des instructions qui, lorsque le programme est exécuté par un ordinateur, conduisent celui-ci à mettre en œuvre toutes les étapes du procédé selon l'une quelconque des revendications 1 à 11.

13. Dispositif de traitement de données comprenant un processeur (24) configuré pour mettre en œuvre toutes les étapes du procédé selon l'une quelconque des revendications 1 à 11.

14. Appareil de détection de métaux portatif (10) comprenant un dispositif selon la revendication 13 ainsi qu'au moins un transducteur électroacoustique (13) pour restituer le signal audio à un utilisateur de l'appareil.

## Patentansprüche

1. Verfahren zur Erzeugung eines Audiosignals für die akustische Wiedergabe an den Benutzer eines tragbaren Metalldetektionsgeräts (10) mit Hilfe mindestens eines elektroakustischen Wandlers, eines elektromagnetischen Detektionssignals eines Ziels, dessen Amplitude mit einer bestimmten Dynamik variieren kann, das Verfahren umfassend die folgenden Schritte:
- Reduzierung der Dynamik des Detektionssignals, damit sie einer gewünschten Dynamik des Audiosignals entspricht; und
- Erzeugung (27, 28) des Audiosignals in Abhängigkeit von dem Detektionssignal mit der reduzierten Dynamik,
wobei:
- die Reduzierung der Dynamik des Detektionssignals umfasst:
- Begrenzung (22) des Detektionssignals in Abhängigkeit von einem bestimmten Detektionsschwellenwert; wobei die Begrenzung (22) des Detektionssignals die Begrenzung des Signals unterhalb des Detektionsschwellenwerts umfasst;
- Anwendung (24) einer bestimmten Gesamtkompressionsrate der Dynamik auf das begrenzte Detektionssignal, wobei die Gesamtkompressionsrate der Dynamik eine Funktion des Verhältnisses zwischen der Dynamik des Detektionssignals und der gewünschten Dynamik des Audiosignals ist; und
- Verzögerung (25) des komprimierten Detektionssignals, um einen gewünschten Mindestpegel des Audiosignals einzustellen; und
**dadurch gekennzeichnet, dass**:
die bestimmte Gesamtkompressionsrate der Dynamik streng zwischen 0 und 1 liegt; und
- die Anwendung (24) der Gesamtkompressionsrate der Dynamik auf das begrenzte Detektionssignal das Segmentieren der Dynamik des Detektionssignals in eine Vielzahl separater Abschnitte (Z1, Z2, Z3) sowie die Anwendung jeweiliger lokaler Änderungsraten der Dynamik auf verschiedene Abschnitte des begrenzten Detektionssignals umfasst.

2. Verfahren nach Anspruch 1, wobei Abschnitte der Dynamik des Detektionssignals durch lineare Segmente definiert sind.

3. Verfahren nach einem der Ansprüche 1 und 2, wobei mindestens eine lokale Änderungsrate der Dynamik größer oder gleich eins ist.

4. Verfahren nach einem der Ansprüche 1 bis 3, das vor dem Schritt der Reduzierung der Dynamik des Detektionssignals zusätzlich eine logarithmische Umwandlung (21) des Detektionssignals nach einer logarithmischen Skala umfasst,
und bei dem die Anwendung (24) der Gesamtkompressionsrate der Dynamik auf das begrenzte Detektionssignal oder die Anwendung einer lokalen Änderungsrate der Dynamik auf einen bestimmten Abschnitt des begrenzten Detektionssignals das Multiplizieren des begrenzten Detektionssignals oder des Abschnitts des begrenzten Detektionssignals mit der Gesamtkompressionsrate der Dynamik oder der lokalen Änderungsrate der Dynamik umfasst.

5. Verfahren nach Anspruch 4, das ferner nach der Reduzierung der Dynamik des Detektionssignals und vor der Erzeugung des Audiosignals eine umgekehrte Umwandlung (26) der logarithmischen Umwandlung des empfangenen Detektionssignals umfasst, um die Dynamik des komprimierten und verzögerten Detektionssignals auf eine lineare Skala zurückzuführen.

6. Verfahren nach einem der Ansprüche 4 oder 5, wobei die Verzögerung (25) des komprimierten Detektionssignals das Hinzufügen eines Werts umfasst, der einem gewünschten Mindestpegel des Audiosignals entspricht.

7. Verfahren nach einem der Ansprüche 1 bis 6, wobei der Detektionsschwellenwert und/oder der Wert, der dem gewünschten Mindestpegel des Audiosignals entspricht, programmierbar sind (22a, 25a).

8. Verfahren nach einem der Ansprüche 1 bis 7, wobei die Erzeugung des Audiosignals die Erzeugung (27) eines akustischen Signals, aufweisend eine Grundkomponente bestimmter Tonhöhe, sowie die Modulation (28) des akustischen Signals durch das komprimierte und verzögerte Detektionssignal umfasst.

9. Verfahren nach einem der Ansprüche 2 bis 8, wobei die Erzeugung des Audiosignals zusätzlich eine Klangfarbenveränderung (27a) des akustischen Signals zwischen zwei jeweiligen Abschnitten der Dynamik des Detektionssignals umfasst.

10. Verfahren nach Anspruch 9, wobei die Klangfarbenveränderung des akustischen Signals zwischen zwei benachbarten Abschnitten der Dynamik des Detektionssignals von einem Abschnitt zum anderen progressiv ist.

11. Verfahren nach einem der Ansprüche 1 bis 10, wobei die Reduzierung der Dynamik des empfangenen Detektionssignals außerdem umfasst, nach dem Begrenzen (22) des Detektionssignals, aber vor dem Anwenden (24) der Gesamtkompressionsrate der Dynamik auf das begrenzte Detektionssignal, eine Einweg-Gleichrichtung (23) des begrenzten Detektionssignals.

12. Computerprogrammprodukt, umfassend Befehle, die, wenn das Programm von einem Computer ausgeführt wird, diesen veranlassen, alle Schritte des Verfahrens nach einem der Ansprüche 1 bis 11 auszuführen.

13. Datenverarbeitungsvorrichtung, umfassend einen Prozessor (24), der so konfiguriert ist, dass er alle Schritte des Verfahrens nach einem der Ansprüche 1 bis 11 ausführt.

14. Tragbares Metalldetektionsgerät (10), umfassend eine Vorrichtung nach Anspruch 13 sowie mindestens einen elektroakustischen Wandler (13) zur Wiedergabe des Audiosignals an einen Benutzer des Geräts.

## Claims

1. Method for generating an audio signal for the acoustic rendering, to the user of a portable metal detection apparatus (10), using at least one electroacoustic transducer, of an electromagnetic target detection signal the amplitude of which may vary with a determined dynamic range, the method comprising the following steps:
- reducing the dynamic range of the detection signal so that it corresponds to a desired dynamic range of the audio signal; and
- generating (27, 28) the audio signal on the basis of the detection signal with the reduced dynamic range,
wherein:
- reducing the dynamic range of the detection signal comprises:
- - clipping (22) the detection signal on the basis of a determined detection threshold; clipping (22) the detection signal comprising clipping said signal below the detection threshold;
- - applying (24), to the clipped detection signal, an overall determined dynamic range compression rate, which depends on the ratio between the dynamic range of the detection signal and the desired dynamic range of the audio signal; and
- - shifting (25) the compressed detection signal so as to set a desired minimum level of the audio signal; and
**characterized in that** :
the overall determined dynamic range compression rate is strictly between 0 and 1; and
- applying (24) the overall dynamic range compression rate to the clipped detection signal comprises segmenting the dynamic range of the detection signal into a plurality of separate portions (Z1, Z2, Z3), and also applying respective local dynamic range modification rates to different portions of the clipped detection signal.

2. Method according to Claim 1, wherein some portions of the dynamic range of the detection signal are defined by linear segments.

3. Method according to either one of Claims 1 and 2, wherein at least one local dynamic range modification rate is greater than or equal to unity.

4. Method according to any one of Claims 1 to 3, furthermore comprising, before the step of reducing the dynamic range of the detection signal, logarithmic conversion (21) of said detection signal on a logarithmic scale,
and wherein applying (24) the overall dynamic range compression rate to the clipped detection signal or applying a local dynamic range modification rate to a determined portion of the clipped detection signal comprises multiplying said clipped detection signal or said clipped detection signal portion, respectively, by said overall dynamic range compression rate or by said local dynamic range modification rate, respectively.

5. Method according to Claim 4, furthermore comprising, after reducing the dynamic range of the detection signal and before generating the audio signal, inverse conversion (26) of the logarithmic conversion of the received detection signal in order to return the dynamic range of the compressed and shifted detection signal to a linear scale.

6. Method according to either one of Claims 4 and 5, wherein:
- shifting (25) the compressed detection signal comprises adding a value corresponding to a desired minimum level of the audio signal.

7. Method according to any one of Claims 1 to 6, wherein the detection threshold and/or the value corresponding to the desired minimum level of the audio signal are programmable (22a, 25a).

8. Method according to any one of Claims 1 to 7, wherein generating the audio signal comprises generating (27) an acoustic signal having a fundamental component of a determined level, and modulating (28) said acoustic signal with the compressed and shifted detection signal.

9. Method according to any one of Claims 2 to 8, wherein generating the audio signal furthermore comprises changing the timbre (27a) of the acoustic signal between two respective portions of the dynamic range of the detection signal.

10. Method according to Claim 9, wherein the change in timbre of the acoustic signal between two contiguous portions of the dynamic range of the detection signal is gradual from one to the other.

11. Method according to any one of Claims 1 to 10, wherein reducing the dynamic range of the received detection signal furthermore comprises, after clipping (22) the detection signal but before applying (24) the overall dynamic range compression rate to the clipped detection signal, half-wave rectification (23) of said clipped detection signal.

12. Computer program product comprising instructions that, when the program is executed by a computer, prompt said computer to implement all of the steps of the method according to any one of Claims 1 to 11.

13. Data processing device comprising a processor (24) configured to implement all of the steps of the method according to any one of Claims 1 to 11.

14. Portable metal detection apparatus (10) comprising a device according to Claim 13 and at least one electroacoustic transducer (13) for rendering the audio signal to a user of the apparatus.
